# DEMANDE DE BREVET EUROPEEN

(11) **EP 1 892 719 A1**
(43) Date de publication de la demande: **27.02.2008**
(21) Numéro de dépôt: 07366003.7
(22) Date de dépôt: 10.08.2007
(51) Int. Cl.: G11C 11/412

(54) **Cellule logique protégée contre les aléas**

(30) Priorité: 24.08.2006 FR 0653444
(71) Demandeur: STMICROELECTRONICS SA, 92120 Montrouge (FR)
(72) Inventeur: Gasiot, GIlles, 57070 Metz (FR); Jacquet, Francois, 57070 Metz (FR); Roche, Philippe, 57070 Metz (FR)
(74) Mandataire: Bentz, Jean-Paul

(57) **Abrégé**

L'invention concerne une cellule mémoire susceptible de mémoriser une information sous la forme d'un premier niveau logique et d'un deuxième niveau logique complémentaires l'un de l'autre, comprenant un premier moyen de stockage (MS1) et un deuxième moyen de stockage (MS2) aptes chacun à mémoriser le premier niveau logique et le deuxième niveau logique.

Selon l'invention, la cellule mémoire comprend également un moyen d'isolement pour, en dehors d'un accès à la cellule mémoire, isoler électriquement une entrée (E1) du premier moyen de stockage d'une sortie (S2) du deuxième moyen de stockage, et / ou une entrée (E2) du deuxième moyen de stockage d'une sortie (S1) du premier moyen de stockage.

Application à la réalisation de mémoires de type SRAM.

## Description

L'invention concerne de manière générale une cellule mémoire susceptible de mémoriser une information sous la forme d'un premier niveau logique et d'un deuxième niveau logique complémentaires l'un de l'autre, et comprenant un premier moyen de stockage et un deuxième moyen de stockage aptes chacun à mémoriser le premier niveau logique et le deuxième niveau logique.

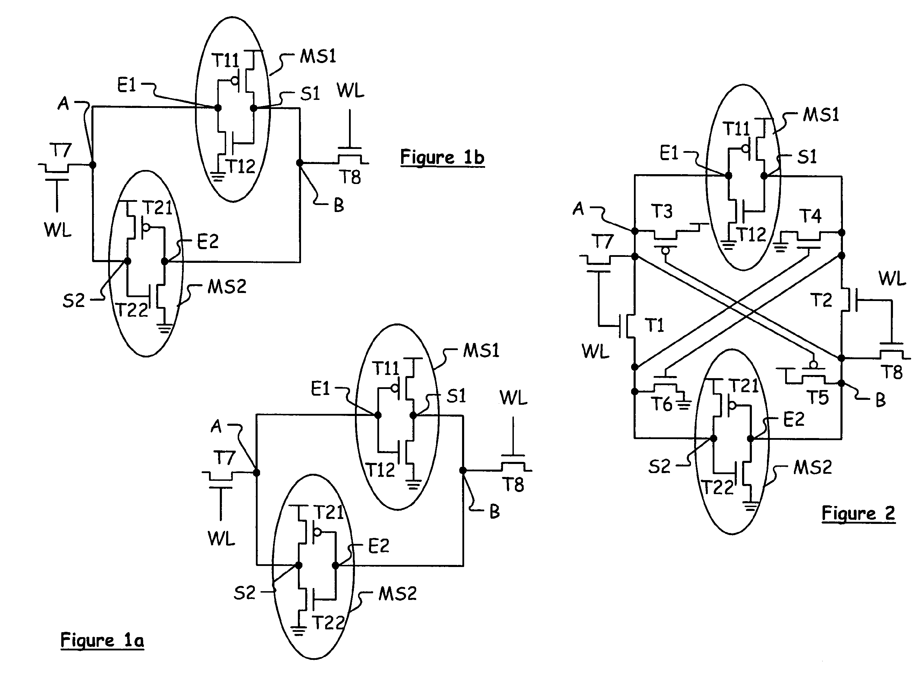

Une telle cellule mémoire de type SRAM simple comprend (figures 1a, 1b) deux points de mémorisation A, B, deux transistors d'accès T7, T8 de type approprié, chacun reliant un point de mémorisation de la cellule à une ligne de mots WL ou /WL (complémentaire de WL) associée, et deux moyens de stockage MS1, MS2 connectés tête-bêche. Les points de mémorisation A, B mémorisent des niveaux logiques complémentaires.
Dans l'exemple de la figure 1a, les moyens de stockage MS1, MS2 de la cellule mémoire, également connue sous le nom anglo-saxon "latch", sont deux inverseurs connectés tête-bêche entre les points de mémorisation A, B. Chaque inverseur est réalisé de manière connue par deux transistors de types différents connectés en série entre une borne d'alimentation VDD de l'inverseur et une masse GND du circuit, le drain commun des transistors formant la sortie de l'inverseur et la grille commune des inverseurs formant l'entrée de l'inverseur.
Dans l'exemple de la figure 1b, les moyens de stockage MS1, MS2 de la cellule mémoire comprennent chacun deux transistors connectés tête-bêche (les transistors T11, T12 pour le premier moyen de stockage MS1, T21, T22 pour le deuxième moyen de stockage MS2). D'un point de vue électrique, le comportement des cellules mémoires des figures 1a, 1b est le même. Les cellules diffèrent simplement par la connexion des transistors T12, T22.
Pour programmer un "1" logique dans la cellule de la figure 1b, on applique un signal d'accès WL actif sur les grilles des transistors T7, T8, et des potentiels complémentaires sur les sources des transistors T7, T8 : par exemple VDD sur la source de T7 et GND sur la source de T8. Pendant la programmation d'un "1", le deuxième moyen de stockage MS1 est actif : ses transistors T21, T22 sont passant, le potentiel VDD (correspondant à "1") apparaît sur sa sortie S2, le potentiel GND apparaît sur son entrée E2 (correspondant à "0"). Le premier moyen de stockage MS2 est par contre passif : ses transistors T11, T12 sont bloqués. Le potentiel VDD sur l'entrée E1 est imposé par le potentiel sur la sortie S2 et le potentiel GND sur la sortie S1 est imposé par le potentiel sur l'entrée E2. Bien sûr, pour programmer un "0", on applique un signal d'accès WL actif sur les grilles des transistors T7, T8, et des potentiels complémentaires inverses sur les sources des transistors T7, T8 : GND sur la source de T7 et VDD sur la source de T8. Le comportement du premier moyen de stockage et du deuxième moyen de stockage est inversé par rapport au cas où un "1" est programmé.
Pour lire le contenu de la cellule de la figure 1b, on applique simplement le signal d'accès WL actif sur les grilles des transistors T7, T8, et on mesure les potentiels sur les sources des transistors T7, T8.

Les cellules mémoires sont très sensibles aux aléas logiques (ou "soft errors"), c'est-à-dire à la perte d'information due, au niveau d'un point de mémorisation où l'un des deux niveaux logiques est stocké, à un apport d'énergie venant de l'extérieur et non souhaité.

Les aléas logiques peuvent avoir des origines différentes. Un aléa logique est par exemple induit par l'impact d'une particule énergétique, par exemple un ion lourd, en un point de mémorisation du circuit. Un tel aléa est connu sous l'expression anglo-saxonne "Single Event Upset" (ou SEU). Un aléa logique peut également être induit par un couplage capacitif ponctuel entre deux couches d'un même circuit intégré. On parle souvent dans ce cas de "glitchs" ou de "Single Event Transient" (ou SET).
Les circuits électroniques sont de plus en plus sensibles aux aléas logiques, au fur et à mesure que la taille de leur composant diminue. Ainsi, pour des circuits réalisés dans des technologies inférieures ou égales à 0,25µm, les aléas logiques sont trop fréquents pour être négligés.
Dans la mesure où la tendance est à l'utilisation de technologies de plus en plus petites, et notamment inférieures à 0,25µm, les problèmes de sensibilité des circuits électroniques apparaissent maintenant couramment dans le domaine du matériel informatique, mais également dans les domaines variés tels que le transport, l'avionique, le matériel médical, etc.

L'impact d'une particule énergétique ou le couplage capacitif de deux couches entraîne un apport de charge au niveau du circuit qui se traduit en général par un pic de courant et par un pic de tension, sur un signal digital ou analogique, en un point d'un circuit (point d'impact dans le cas d'un SEU, point de couplage dans le cas d'un glitch, etc.). La variation de tension est en général de très courte durée, typiquement de l'ordre de quelques picosecondes à quelques centaines de picosecondes.
La variation de tension peut par contre être d'amplitude très importante dans une cellule SRAM. Le point de mémorisation de la cellule SRAM se comporte en effet comme une capacité que viennent charger les paires d'électrons / trous créées lors de l'impact de la particule énergétique ou du couplage capacitif de deux couches. Si l'on note C la valeur de la capacité et ΔQ la variation de charge de la capacité résultant de l'apport de charges externes, il s'ensuit une variation de tension ΔV aux bornes de la capacité telle que ΔV = ΔQ/C.
Les technologies actuelles permettent de réaliser des circuits dont les dimensions sont de plus en plus petites. La capacité C des points de mémorisation peut alors atteindre des valeurs très faibles, de sorte que, même pour une faible quantité de charges ΔQ, la variation de tension ΔV peut atteindre un niveau important. Une variation importante de tension peut entraîner le basculement du niveau logique qui est stocké dans le point de mémorisation qui subit la variation de tension. Le basculement d'un niveau logique entraîne alors le basculement du niveau logique complémentaire. Comme les niveaux logiques complémentaires se confirment l'un l'autre, la cellule mémoire se trouve dans un état stable différent de l'état initial.
Par exemple, après programmation d'un "1" dans la cellule de la figure 1b, le potentiel au point A est égal à VDD et le potentiel au point B est égal à GND. Le deuxième moyen de stockage est actif ; si un aléa vient par exemple perturber la grille du transistor T22, le potentiel VDD est immédiatement rétabli sur la grille par le transistor T21 qui est passant.
Le premier moyen de stockage est par contre passif ; si un aléa vient par exemple perturber la grille du transistor T12, le transistor T11, inactif, n'est pas en mesure de rétablir le potentiel GND sur la grille de T12. T12 devient passant et le potentiel GND apparaît sur le drain de T12 et le drain de T11 (basculement du premier moyen de stockage), ainsi que sur la grille de T22 qui se bloque ; la grille de T12 et le drain de T11 imposent alors le potentiel VDD sur la grille de T21 et le drain de T22 (basculement du deuxième moyen de stockage). La cellule mémoire a ainsi changé d'état.

Pour remédier à ce problème, les documents D1 (US 6,147,899) et D2 (US 5,570,313) proposent de réaliser des cellules doubles, comprenant deux cellules simples (telles que représentées sur la figure 1a ou 1b) connectées tête-bêche de sorte que, si le contenu d'une cellule simple est perturbé par un aléa, l'autre cellule vient restaurer le contenu de la cellule simple perturbé.
Ces solutions ne sont toutefois pas satisfaisantes. Elles présentent en effet une sensibilité dissymétrique (selon le point de mémorisation qui reçoit des charges externes), ou bien elles sont difficiles à mettre en oeuvre concrètement dans un circuit intégré : deux cellules volumineuses qu'il est difficile de rapprocher, liaisons entre les deux cellules longues et difficiles à positionner entre les composants des deux cellules, sensibilité qui, bien que diminuée, reste élevée, etc.

L'invention propose une nouvelle cellule mémoire, mieux protégée contre les aléas et éventuellement plus facile à mettre en oeuvre que les cellules mémoires connues.
Ainsi, l'invention concerne une cellule mémoire susceptible de mémoriser une information sous la forme d'un premier niveau logique et d'un deuxième niveau logique complémentaires l'un de l'autre, comprenant un premier moyen de stockage et un deuxième moyen de stockage aptes chacun à mémoriser le premier niveau logique et le deuxième niveau logique.

La cellule mémoire selon l'invention est caractérisée en ce qu'elle comprend également un moyen d'isolement pour, en dehors d'un accès à la cellule mémoire, isoler électriquement une entrée du premier moyen de stockage d'une sortie du deuxième moyen de stockage, et / ou une entrée du deuxième moyen de stockage d'une sortie du premier moyen de stockage.

Lors d'un accès à la cellule mémoire, pour inscrire une information dans la cellule mémoire ou pour lire le contenu de la cellule mémoire, le moyen d'isolement relie le premier moyen de stockage et le deuxième moyen de stockage ; le comportement de la cellule mémoire est ainsi identique au comportement d'une cellule mémoire connue lors d'une écriture ou d'une lecture de la dite cellule.
Par contre, en dehors d'un accès à la cellule mémoire, c'est à dire en dehors des phases d'écriture ou de lecture de la cellule mémoire, et notamment lors d'une phase de rétention d'information de la cellule, le premier moyen de stockage et le deuxième moyen de stockage sont isolés l'un de l'autre. Ainsi, une modification du contenu dans l'un des moyens de stockage suite à un aléa logique n'entraîne pas le basculement de l'autre des moyens de stockage ; l'information correcte est ainsi conservée dans la cellule mémoire.
La cellule selon l'invention est de préférence complétée par l'ajout d'un moyen de restauration, pour relier électriquement l'entrée du premier moyen de stockage à l'entrée du deuxième moyen de stockage, et / ou la sortie du deuxième moyen de stockage à la sortie du premier moyen de stockage.
En dehors d'un accès (en écriture ou en lecture) à la cellule mémoire, si un aléa logique vient modifier le contenu de l'un des moyens de stockage, alors le moyen de restauration permet à l'autre des moyens de stockage de restaurer le contenu erroné, comme on le verra mieux par la suite.

L'invention sera mieux comprise et d'autres caractéristiques et avantages apparaîtront à la lecture de la description qui va suivre, d'exemples de mise en oeuvre d'un circuit électronique selon l'invention. La description, faite à titre indicatif et nullement limitatif, est à lire en relation aux dessins annexés dans lesquels :
• les figures 1a, 1b, déjà décrites, présentent des cellules mémoires SRAM non protégées contre les aléas,
• la figure 2 présente une cellule mémoire selon l'invention.

Comme il a été dit précédemment, l'invention concerne une cellule mémoire susceptible de mémoriser une information sous la forme d'un premier niveau logique, et d'un deuxième niveau logique, complémentaires l'un de l'autre. De même qu'une cellule antérieure, la cellule de l'invention comprend un premier moyen de stockage MS1 et un deuxième moyen de stockage MS2 aptes chacun à mémoriser le premier niveau logique et le deuxième niveau logique.
Si la cellule mémorise un "1" logique, le premier niveau logique est par exemple égal à VDD, un potentiel d'alimentation de la cellule, et le deuxième niveau logique est par exemple égal à un potentiel de masse. Inversement, si la cellule mémorise un "0" logique, le premier niveau logique est par exemple égal au potentiel de masse et le deuxième niveau logique est par exemple égal au potentiel VDD.

Le premier moyen de stockage MS1 comprend une entrée E1 et une sortie S1, sur lesquelles sont mémorisés respectivement le premier niveau et le deuxième niveau. Le deuxième moyen de stockage comprend une entrée E2 et une sortie S2 sur lesquelles sont mémorisées respectivement le deuxième niveau et le premier niveau.
La cellule comprend également un moyen d'accès, pour accéder en lecture ou en écriture au premier moyen de stockage et au deuxième moyen de stockage. Le moyen d'accès comprend dans l'exemple de la figure 2 un transistor T7 et un transistor T8. Le transistor T7 a un drain connecté à l'entrée du premier moyen de stockage et un signal d'accès WL est appliqué sur sa grille de commande. Le transistor T8 a un drain connecté à l'entrée du deuxième moyen de stockage et le signal d'accès WL est appliqué sur sa grille.
Dans la cellule de la figure 1b, le premier moyen de stockage comprend :
• un transistor d'un premier type T11 dont une grille est connectée à l'entrée du moyen de stockage et dont un canal est connecté entre une première borne d'alimentation VDD et la sortie du moyen de stockage,
• un transistor d'un deuxième type T12 dont une grille est connectée à la sortie du moyen de stockage et dont un canal est connecté entre l'entrée du moyen de stockage et une deuxième borne d'alimentation GND.

Les transistors T11, T12 sont ainsi connectés tête-bêche : la grille du transistor T11 et le drain du transistor T12 sont connectés ensemble à l'entrée E1 du premier moyen de stockage, la grille du transistor T12 et le drain du transistor T11 sont connectés ensemble à la sortie S1 du premier moyen de stockage, le potentiel d'alimentation VDD est appliqué sur la source du transistor T11 et la source du transistor T12 est connectée à la masse. Le deuxième moyen de stockage est réalisé selon un schéma similaire et comprend deux transistors T21, T22.

La cellule selon l'invention comprend également un moyen d'isolement pour, en dehors d'un accès à la cellule mémoire, isoler électriquement l'entrée E1 du premier moyen de stockage de la sortie S2 du deuxième moyen de stockage, et / ou l'entrée E2 du deuxième moyen de stockage de la sortie S1 du premier moyen de stockage.
Ainsi, lors d'un accès à la cellule, en lecture ou en écriture, le premier moyen de stockage et le deuxième moyen de stockage sont reliés électriquement : le fonctionnement de la cellule de la figure 2 est dans ce cas identique au fonctionnement de la cellule de la figure 1b, lors d'une écriture ou d'une lecture de la cellule.
Par contre, en dehors d'un accès à la cellule (c'est-à-dire pendant la phase de rétention de la cellule), le premier moyen de stockage et le deuxième moyen de stockage sont isolés l'un de l'autre. Un aléa qui viendrait perturber le moyen de stockage passif (MS1 ou MS2 selon la valeur programmée dans la cellule) n'entraînera pas le basculement du moyen de stockage actif (MS2 ou MS1 selon la valeur programmée dans la cellule).

Dans l'exemple de la figure 2, le moyen d'isolement comprend :
• un premier transistor T1 dont un canal est connecté entre l'entrée E1 du premier moyen de stockage MS1 et la sortie S2 du deuxième moyen de stockage MS2, et / ou
• un deuxième transistor T2 dont un canal est connecté entre l'entrée E2 du deuxième moyen de stockage MS2 et la sortie S1 du premier moyen de stockage MS1.

Dans l'exemple de la figure 2 également, le moyen d'accès et le moyen d'isolement sont activés par un même signal d'accès (WL) à la cellule mémoire. Pour cela, le signal WL est appliqué sur les grilles des transistors T1, T2 d'une part, et T7, T8 d'autres part. Ceci est dû au choix de transistors de type N pour les transistors T1, T2, T7, T8.
Mais il est aussi possible de choisir des transistors de type P complémentaire de N, pour les transistors T1, T2 (T7, T8 restant des transistors N) ou bien pour les transistors T7, T8 (T1, T2 restant des transistors N), ou bien pour les transistors T1, T2, T7, T8. Les transistors P seront alors commandés par un signal /WL complémentaire.

La cellule mémoire selon l'invention est avantageusement complétée par un moyen de restauration, pour relier électriquement l'entrée E1 du premier moyen de stockage MS1 à l'entrée E2 du deuxième moyen de stockage MS2, et / ou la sortie S2 du deuxième moyen de stockage à la sortie S1 du premier moyen de stockage MS1.
L'intérêt du moyen de restauration est le suivant.
En dehors des phases d'accès en lecture ou en écriture à la cellule mémoire de la figure 2, c'est-à-dire en dehors des phases de programmation ou de lecture de la cellule mémoire, le moyen d'isolement (les transistors T1, T2) est ouvert et les moyens de stockage MS1, MS2 sont isolés l'un de l'autre. Si un aléa vient modifier l'information contenue dans le moyen d'isolement qui est passif (MS1 ou MS2 selon le cas), alors lors d'un accès ultérieur en lecture de la cellule mémoire, un conflit risque d'apparaître entre l'information erronée contenue dans le moyen de stockage passif et l'information correcte contenue dans le moyen de stockage actif.

Le moyen de restauration permet d'éviter ce conflit ; il permet en effet au moyen de stockage actif, notamment en dehors des phases d'accès à la cellule mémoire, de restaurer une information erronée dans le moyen de stockage passif. Tout risque de conflit ultérieur est ainsi supprimé.
Dans l'exemple représenté sur la figure 2, le moyen de restauration comprend:
• un troisième transistor T3 dont une grille est connectée à l'entrée du deuxième moyen de stockage et dont un drain est connecté à l'entrée du premier moyen de stockage, et / ou
• un quatrième transistor T4 dont une grille est connectée à la sortie du deuxième moyen de stockage et dont un drain est connecté à la sortie du premier moyen de stockage, et / ou
• un cinquième transistor T5 dont une grille est connectée à l'entrée du premier moyen de stockage et dont un drain est connecté à l'entrée du deuxième moyen de stockage, et / ou
• un sixième transistor T6 dont une grille est connectée à la sortie du deuxième moyen de stockage et dont un drain est connecté à la sortie du premier moyen de stockage.

La source de T3 et la source de T5 sont connectées à la borne d'alimentation VDD. La source de T4 et la source de T6 sont connectées à la borne d'alimentation GND (masse du circuit).

## Revendications

1. Cellule mémoire susceptible de mémoriser une information sous la forme d'un premier niveau logique et d'un deuxième niveau logique complémentaires l'un de l'autre, comprenant un premier moyen de stockage (MS1) et un deuxième moyen de stockage (MS2) aptes chacun à mémoriser le premier niveau logique et le deuxième niveau logique,
la cellule mémoire étant **caractérisée en ce qu'**elle comprend également un moyen d'isolement pour, en dehors d'un accès à la cellule mémoire, isoler électriquement une entrée (E1) du premier moyen de stockage d'une sortie (S2) du deuxième moyen de stockage, et / ou une entrée (E2) du deuxième moyen de stockage d'une sortie (S1) du premier moyen de stockage.

2. Cellule mémoire selon la revendication 1, dans laquelle le moyen d'isolement comprend :
• un premier transistor (T1) dont un canal est connecté entre l'entrée (E1) du premier moyen de stockage et la sortie (S2) du deuxième moyen de stockage, et / ou
• un deuxième transistor (T2) dont un canal est connecté entre l'entrée (E2) du deuxième moyen de stockage et la sortie (S1) du premier moyen de stockage.

3. Cellule mémoire selon la revendication 1 ou 2, comprenant également un moyen de restauration, pour relier électriquement l'entrée (E1) du premier moyen de stockage à l'entrée (E2) du deuxième moyen de stockage, et / ou la sortie (S2) du deuxième moyen de stockage à la sortie (S1) du premier moyen de stockage.

4. Cellule mémoire selon la revendication 3, dans laquelle le moyen de restauration comprend :
• un troisième transistor (T3) dont une grille est connectée à l'entrée du deuxième moyen de stockage et dont un drain est connecté à l'entrée du premier moyen de stockage, et / ou
• un quatrième transistor (T4) dont une grille est connectée à la sortie du deuxième moyen de stockage et dont un drain est connecté à la sortie du premier moyen de stockage, et / ou
• un cinquième transistor (T5) dont une grille est connectée à l'entrée du premier moyen de stockage et dont un drain est connecté à l'entrée du deuxième moyen de stockage, et / ou
• un sixième transistor (T6) dont une grille est connectée à la sortie du deuxième moyen de stockage et dont un drain est connecté à la sortie du premier moyen de stockage.

5. Cellule mémoire selon l'une des revendications précédentes, comprenant également un moyen d'accès, pour accéder en lecture ou en écriture au premier moyen de stockage et au deuxième moyen de stockage.

6. Cellule mémoire selon la revendication 5, dans laquelle le moyen d'accès et le moyen d'isolement sont activés par un même signal d'accès (WL) à la cellule mémoire, ou par des signaux complémentaires.

7. Cellule mémoire selon l'une des revendications précédentes, dans laquelle le premier et / ou le deuxième moyen de stockage (MS1, MS2) comprend :
• un transistor d'un premier type (T11, T21) dont une grille est connectée à l'entrée du moyen de stockage et dont un canal est connecté entre une première borne d'alimentation (VDD) et la sortie du moyen de stockage,
• un transistor d'un deuxième type (T12, T22) dont une grille est connectée à la sortie du moyen de stockage et dont un canal est connecté entre l'entrée du moyen de stockage et une deuxième borne d'alimentation (GND).
